Europäisches Patentamt

European Patent Office

Office européen des brevets

(11) Veröffentlichungsnummer: **0 509 141 A1**

## EUROPÄISCHE PATENTANMELDUNG

(21) Anmeldenummer: **91119996.6**

(22) Anmeldetag: **23.11.91**

(51) Int. Cl.5: **G01R 33/06**

(30) Priorität: **11.04.91 CH 1086/91**

(43) Veröffentlichungstag der Anmeldung:
**21.10.92 Patentblatt 92/43**

(84) Benannte Vertragsstaaten:
**AT CH DE ES FR GB IT LI SE**

(71) Anmelder: **Landis & Gyr Betriebs AG**

**CH-6301 Zug(CH)**

(72) Erfinder: **Radivoje, Popovic**
**Fridbach 1**
**CH-6300 Zug(CH)**

(54) **Magnetfeldsensor.**

(57) Der Magnetfeldsensor besitzt in einer Variante zwei Kontaktzonen (4, 5), eine Eingangszone (2) und eine Ausgangszone (3), die aus einem stark mit Fremdatomen dotierten Halbleitermaterial eines ersten Leitfähigkeitstyps ($N^+$) bestehen und an einer Aussenfläche in einem Halbleitermaterial (1) eines zweiten Leitfähigkeitstyps (P) angeordnet sind. Ihnen ist je ein Anschluss (S1, S2, C1 bzw. C2) zugeordnet. Eine mit Durchführungen für die letzteren versehene Isolierschicht ist auf der Aussenfläche des Halbleitermaterials (1) des zweiten Leitfähigkeitstyps (P) angeordnet. Auf der Isolierschicht ist eine Reihe länglicher Gateelektroden (7 bis 26) einer ladungsgekoppelten Schaltung (51) angeordnet. Die beiden Enden mindestens einer mittleren der Gateelektroden (15, 16, 17, 18), die auf der Isolierschicht zwischen den beiden Kontaktzonen (4, 5) angeordnet ist, sind mindestens teilweise überlappend über je eine der beiden Kontaktzonen (4, 5) angeordnet. Der Magnetfeldsensor ermöglicht eine hochpräzise Messung von Magnetfeldern und ist mittels einer konventionellen Standard-Integrierten-Schaltungs-MOS-Technologie herstellbar sowie in einer komplexen konventionellen integrierten MOS-Schaltung ohne zusätzliche Prozessschritte integrierbar. Sein Ausgangssignal ist unabhängig von den Eigenschaften des verwendeten Halbleitermaterials und von den Umgebungsbedingungen.

Fig. 1

EP 0 509 141 A1

Die Erfindung bezieht sich auf einen Magnetfeldsensor gemäss dem Oberbegriff des Anspruchs 1.

Der Gegenstand der Erfindung kann als hochpräziser Qualitäts-Magnetfeldsensor in diversen Geräten, wie z. B. in Elektrizitätszählern, in Kompassen oder in Bewegungssensoren, verwendet werden.

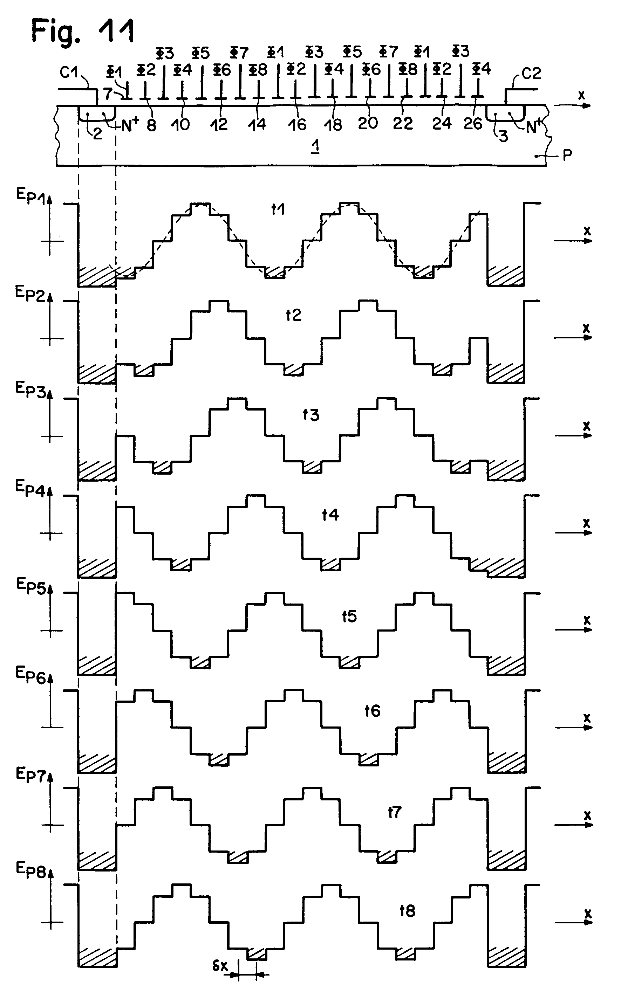

Ein Magnetfeldsensor der im Oberbegriff des Anspruchs 1 genannten Art ist aus der EP 0148 330 A2 bekannt, in der der Aufbau von als Magnetfeldsensoren verwendeten Hallelementen beschrieben ist. Unter anderem ist dort in der Fig. 11 ein Hallelement dargestellt, welches eine erste und zweite Kontaktzone aufweist, die beide aus einem Halbleitermaterial eines Leitfähigkeitstyps P bestehen und an einer Aussenfläche in einem Halbleitermaterial eines anderen Leitfähigkeitstyps N angeordnet sind, wobei ihnen je ein Sensoranschluss S1 bzw. S2 zugeordnet ist. Auf der Aussenfläche des Halbleitermaterials des Leitfähigkeitstyps N ist eine mit Durchführungen für die Sensoranschlüsse S1 und S2 versehene Isolierschicht angeordnet.

In Halleffekt-Bauelementen ist bekanntlich der im Betrieb fliessende elektrische Strom die Folge einer Ladungsträger-Drift oder einer Ladungsträger-Diffusion, wobei der Ladungsträger-Transport von den Eigenschaften des verwendeten Halbleitermaterials und von den Umgebungsbedingungen abhängig ist, so dass eine jede Änderung in denselben eine Änderung des Ausgangssignals des Halleffekt-Bauelementes bewirkt. Im besonderen sind Halleffekt-Bauelemente empfindlich gegenüber Oberflächeneffekte, Verkapselungs-Stress, Licht, Temperatur, Änderungen der Materialdotierungsdichte ("material doping density"), usw. Zwecks Realisierung von Hochpräzisions-Magnetfeldsensoren muss das Halleffekt-Bauelement somit aus einem speziellen Halbleitermaterial mit Hilfe von Nichtstandard-Verfahrensschritten, inklusive einer Spezialverkapselung, hergestellt werden, wobei es ausserdem eine Temperaturkompensation benötigt. Aus diesem Grund ist es schwierig ein gutes Halleffekt-Bauelement in eine Signalaufbereitungsschaltung zu integrieren.

Der Erfindung liegt die Aufgabe zugrunde, einen Magnetfeldsensor der eingangs genannten Art zu verwirklichen, welcher eine hochpräzise Messung von Magnetfeldern ermöglicht, mittels einer konventionellen Standard-Integrierten-Schaltungs-MOS-Technologie herstellbar ist, in einer komplexen konventionellen integrierten MOS-Schaltung ohne zusätzliche Prozessschritte integrierbar ist und dessen Ausgangssignal relativ unabhängig ist von den Eigenschaften des verwendeten Halbleitermaterials und von den Umgebungsbedingungen.

Die genannte Aufgabe wird erfindungsgemäss durch die im Kennzeichen des Anspruchs 1 angegebenen Merkmale gelöst.

Vorteilhafte Ausgestaltungen der Erfindung ergeben sich aus den Unteransprüchen.

Ausführungsbeispiele der Erfindung sind in der Zeichnung dargestellt und werden im folgenden näher beschrieben.

Es zeigen:

Fig. 1 eine schematische Darstellung der Draufsicht einer ersten Variante eines erfindungsgemässen Magnetfeldsensors,

Fig. 2 eine schematische Darstellung der Draufsicht einer zweiten Variante des erfindungsgemässen Magnetfeldsensors,

Fig. 3 einen Querschnitt durch die in der Fig. 2 dargestellte zweite Variante des erfindungsgemässen Magnetfeldsensors,

Fig. 4 eine schematische Darstellung der Draufsicht einer dritten Variante des erfindungsgemässen Magnetfeldsensors,

Fig. 5 eine schematische Darstellung der Draufsicht einer vierten Variante des erfindungsgemässen Magnetfeldsensors,

Fig. 6 eine schematische Darstellung der Draufsicht einer fünften Variante des erfindungsgemässen Magnetfeldsensors,

Fig. 7 eine schematische Darstellung der Draufsicht einer sechsten Variante des erfindungsgemässen Magnetfeldsensors,

Fig. 8 einen Querschnitt durch die erste Variante des erfindungsgemässen Magnetfeldsensors,

Fig. 9 eine Draufsicht der ersten Variante des erfindungsgemässen Magnetfeldsensors,

Fig.10 Zeitdiagramme von an Gateelektroden anstehenden Spannungen,

Fig.11 Diagramme von zu verschiedenen Zeitpunkten unter den Gateelektroden anstehenden potentiellen elektrischen Energien,

Fig.12 einen Querschnitt durch eine siebte Variante des erfindungsgemässen Magnetfeldsensors und

Fig.13 eine Draufsicht der siebten Variante des erfindungsgemässen Magnetfeldsensors.

Gleiche Bezugszahlen bezeichnen in allen Figuren der Zeichnung gleiche Teile.

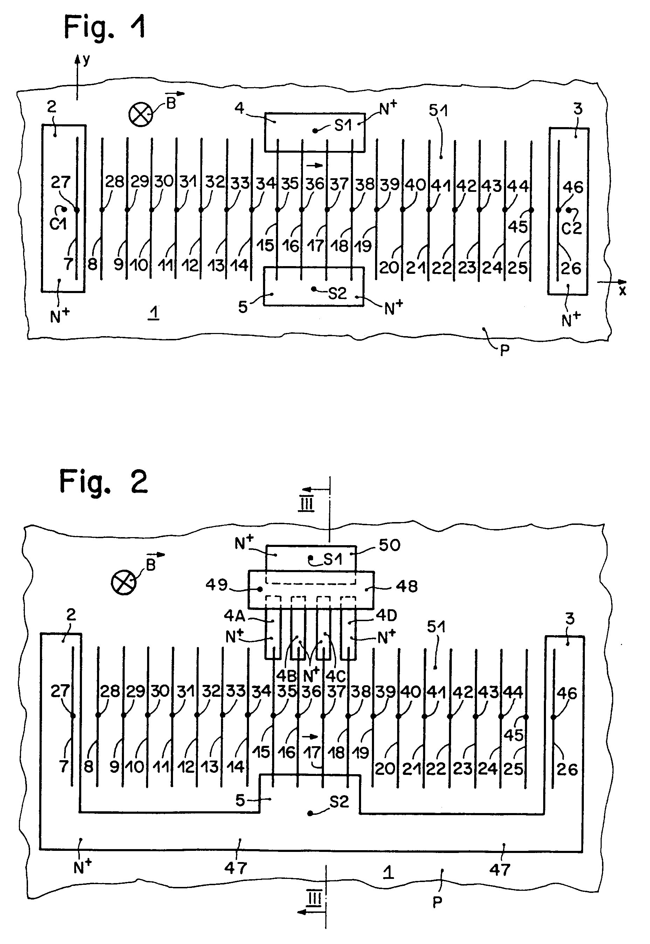

Die in der Fig. 1 schematisch dargestellte erste Variante des erfindungsgemässen Magnetfeldsensors besteht aus einem Halbleitermaterial 1, einer Eingangszone 2, einer Ausgangszone 3, einer ersten Kontaktzone 4, einer zweiten Kontaktzone 5, einer nicht dargestellten Isolierschicht 6 und einer Vielzahl von Gateelektroden 7 bis 26, die je einen Gateanschluss 27, 28, ..., 45 bzw. 46 aufweisen. Die Eingangszone 2, die Ausgangszone 3 und die Gateelektroden 7 bis 26 sind diejenigen einer sogenannten ladungsgekoppelten Schaltung ("charge coupled device": CCD). Der Aufbau von ladungsgekoppelten Schaltungen ist an sich bekannt und z. B. unter anderem in dem Buch "Semiconductor Devices and Semiconductor Electronics", A. G. Milnes, Kapitel 10, Van Nostrand Reinold Co, 1980, beschrieben.

Den beiden Kontaktzonen 4 und 5 ist je ein Sensoranschluss S1 bzw. S2 zugeordnet, die in der Regel unmittelbar mit der betreffenden Kontaktzone 4 bzw. 5 elektrisch verbunden sind. Die im Betrieb zwischen den Sensoranschlüssen S1 und S2 anstehende elektrische Spannung ist eine Ausgangsspannung $V_{S1,S2}$ des erfindungsgemässen Magnetfeldsensors. Die Eingangszone 2 und die Ausgangszone 3 besitzen ebenfalls je einen elektrischen Anschluss C1 bzw. C2.

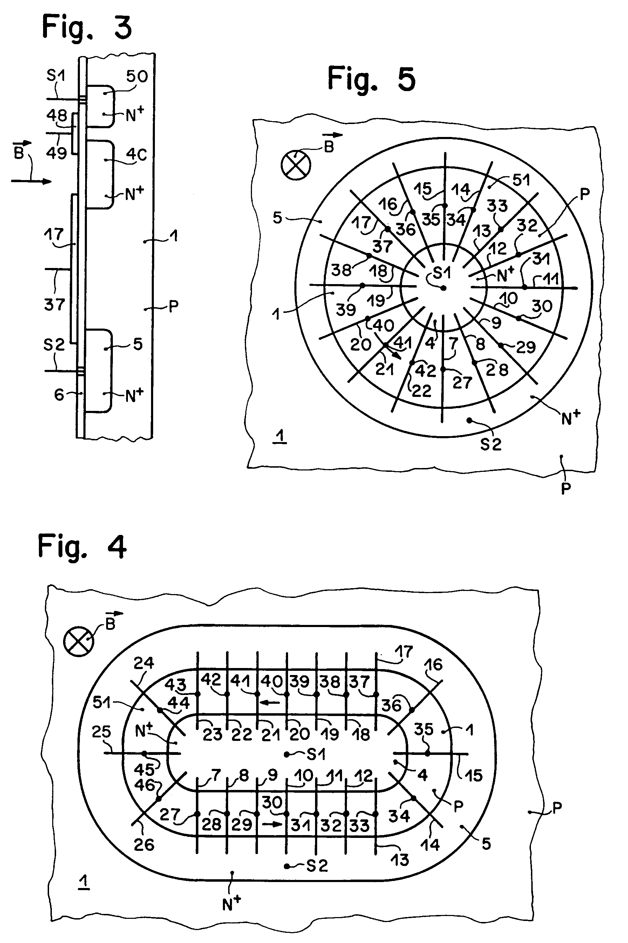

In der Zeichnung gilt die Annahme, dass zwanzig Gateelektroden 7 bis 26 pro ladungsgekoppelte Schaltung vorhanden sind, ausser in der Fig. 5, wo nur sechszehn Gateelektroden 7 bis 22 pro ladungsgekoppelte Schaltung dargestellt sind. Die Gateelektroden bestehen vorzugsweise aus hochdotierten Polykristall-Silizium (Poly-Si) Dünnschichten und sind in der Regel parallel in einem maxi-malen Abstand von zirka $1\mu$ angeordnet. Sie besit-zen je eine Breite in der Grössenordnung von $5\mu$.

Die Isolierschicht 6 ist aus Gründen der zeichnerischen Einfachheit in den Figuren 1 bis 2 und und in den Figuren 4 bis 7 nicht dargestellt, obwohl sie dort auch vorhanden ist. Sie besteht vorzugs-weise aus $SiO_2$ und ist jeweils mit Durchführungen für die Sensoranschlüsse S1 und S2 sowie für die elektrischen Anschlüsse C1 und C2 versehen.

Die Eingangszone 2, die Ausgangszone 3 und die beiden Kontaktzonen 4 und 5 bestehen alle vier aus je einem stark mit Fremdatomen dotierten Halbleitermaterial eines ersten Leitfähigkeitstyps und sind an einer Aussenfläche im Halbleitermaterial 1 angeordnet, welches von einem zweiten Leitfähigkeitstyp ist. Ein zu messendes Magnetfeld und damit auch die dazugehörige Magnetfeldinduktion B ist in den sechs ersten Varianten senkrecht zu dieser Aussenfläche angeordnet. In der Zeichnung gilt die Annahme, dass $N^+$ der erste und P der zweite Leitfähigkeitstyp ist. Die Eingangszone 2 und die Ausgangszone 3 sind parallel zu den Gateelektroden 7 bis 26 in der Nähe der beiden äusseren Gateelektroden, das sind in der Fig. 1 die Gateelektroden 7 und 26, ausserhalb der Elektrodenreihe angeordnet. Die beiden äusseren Gatelektroden überlappen dabei mindestens teilweise die benachbarte Eingangszone 2 bzw. die benachbarte Eingangszone 3 oder sie weisen, ohne Berücksichtigung der Isolierschicht 6, einen Abstand von höchstens einem Mikrometer zu einer Kante derselben auf.

Auf der Aussenfläche des Halbleitermaterials 1 des zweiten Leitfähigkeitstyps P ist die Isolierschicht 6 (siehe Fig. 3, Fig. 8 und Fig. 12) angeordnet. Die Aussenfläche ist dabei vorzugsweise die Oberfläche einer integrierten Schaltung.

Auf der Isolierschicht 6 aller erfindungsgemässen Magnetfeldsensoren sind die Gateelektroden 7 bis 22 bzw. 24 bzw. 26 mindestens einer ladungsgekoppelten Schaltung angeordnet, wobei die betreffenden Gateelektroden in einer Richtung x eine Elektrodenreihe bilden und senkrecht zur Richtung der Reihe länglich streifenförmig sind. Die beiden Enden mindestens einer mittleren der Gateelektroden, die auf der Isolierschicht 6 zwischen den beiden Kontaktzonen 4 und 5 angeordnet ist, sind mindestens teilweise überlappend über je eine der beiden Kontaktzonen 4 und 5 angeordnet. In der Zeichnung wurde in der Regel angenommen, dass die beiden Enden von vier mittleren Gateelektroden, dass sind in der Fig. 1 die vier Gateelektroden 15 bis 18, die beiden Kontaktzonen 4 und 5 überlappen. Die länglichen Gateelektroden 7 bis 26 sind in der ersten Variante parallel zu einer Ordinate y angeordnet und bilden senkrecht zu ihrer Länge in Richtung einer Abszisse x eine gerade Elektrodenreihe. Dabei sind die senkrecht zur Rich-tung der Elektrodenreihe verlaufenden Dimensio-nen der Eingangszone 2, der Ausgangszone 3 und der Gateelektroden 7 bis 26, annähernd gleich gross.

Die in der Fig. 2 und der Fig. 3 dargestellte zweite Variante des erfindungsgemässen Magnetfeldsensors ist ähnlich aufgebaut wie die erste Variante mit zwei Unterschieden, wovon allerdings jeweils einer nur fakultativ in der zweiten Variante vorhanden sein muss. Der erste Unterschied besteht darin, dass eine der beiden Kontaktzonen 4 oder 5, z. B. die zweite Kontaktzone 5, sowie die Eingangszone 2 und die Ausgangszone 3 alle drei mittels mindestens einer elektrischen Verbindung 47 miteinander verbunden sind, wobei die elektrische Verbindung 47 vorzugsweise aus einem stark mit Fremdatomen dotierten Halbleitermaterial des ersten Leitfähigkeitstyps $N^+$ besteht. Der zweite Unterschied besteht darin, dass mindestens eine der beiden Kontaktzonen 4 oder 5, z. B. die erste Kontaktzone 4, aus mehreren Teilkontaktzonen 4A, 4B, 4C und 4D besteht, denen je eine von mehre-ren aufeinanderfolgenden, unterschiedlichen mittle-ren Gateelektroden 15 bzw. 16 bzw. 17 bzw. 18 zugeordnet ist, deren eines Ende über die zugehörige Teilkontaktzone 4A bzw. 4B bzw. 4C bzw. 4D

mindestens teilweise überlappend angeordnet ist. Ausserdem ist auf der Isolierschicht 6 mindestens eine Lese-Gateelektrode 48 angeordnet (siehe Fig. 3), die jeweils über die Teilkontaktzonen 4A, 4B, 4C und 4D sowie über eine weitere Kontaktzone 50 mindestens teilweise überlappend angeordnet ist. Dabei ist die weitere Kontaktzone 50 mit demjenigen Sensoranschluss S1 verbunden, der der aus mehreren Teilkontaktzonen 4A, 4B, 4C und 4D bestehenden Kontaktzone 4 zugeordnet ist. Sie besteht aus einem stark mit Fremdatomen dotierten Halbleitermaterial des ersten Leitfähigkeitstyps $N^+$ und ist an der Aussenfläche in das Halbleitermaterial 1 des zweiten Leitfähigkeitstyps P angeordnet. Die Teilkontaktzonen 4A bis 4D sind annähernd gleich breit wie eine der Gateelektroden 7 bis 26. Die Lese-Gateelektrode 48 besitzt einen elektrischen Anschluss 49.

Die in der Fig. 4 dargestellte dritte Variante des erfindungsgemässen Magnetfeldsensors entspricht annähernd der zweiten Variante, mit dem Unterschied, dass die erste Kontaktzone 4 nicht aus Teilkontaktzonen 4A bis 4B besteht, dass die Eingangszone 2 und die Ausgangszone 3 fehlen, dass eine der beiden Kontaktzonen 4 oder 5, z. B. die erste Kontaktzone 4, zentral angeordnet ist und dass die andere der beiden Kontaktzonen 5 oder 4, z.B. die zweite Kontaktzone 5, die Gestalt eines Ringes aufweist, welcher die zentral angeordnete Kontaktzone 4 distanziert umgibt. Die länglichen Gateelektroden 7 bis 26 sind senkrecht zum Umfang des Ringes auf der Isolierschicht 6 zwischen den beiden Kontaktzonen 4 und 5 angeordnet und ihre beiden Enden über je eine der beiden Kontaktzonen 4 und 5 mindestens teilweise überlappend angeordnet.

Die in der Fig. 5 dargestellte vierte Variante des erfindungsgemässen Magnetfeldsensors entspricht annähernd der dritten Variante mit den Unterschieden, dass die zentral angeordnete erste Kontaktzone 4 die Gestalt eines Kreises besitzt, dass die die Gestalt eines Ringes aufweisende zweite Kontaktzone 5 die Gestalt eines Kreisringes aufweist und dass beide Kontaktzonen 4 und 5 konzentrisch sind.

In der dritten und vierten Variante sind der Ausgang und der Eingang der ladungsgekoppelten Schaltung praktisch miteinander verbunden, so dass Ladungsträger zirkular transportiert werden.

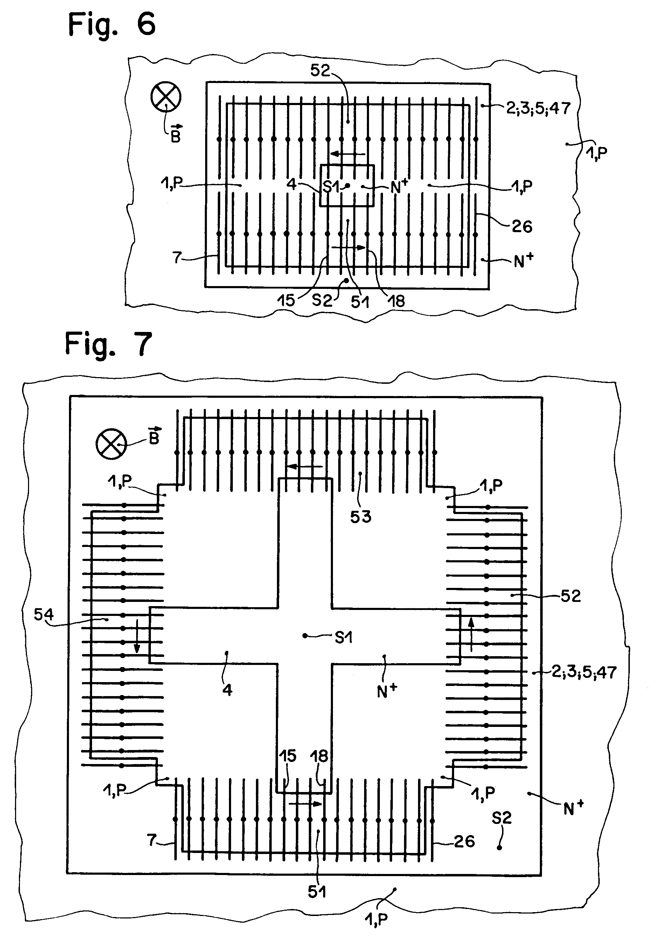

In den vier ersten Varianten sowie in der noch nachfolgend beschriebenen siebten Variante ist jeweils nur eine einzige ladungsgekoppelte Schaltung 51 vorhanden. In der in der Fig. 6 und der Fig. 7 dargestellten fünften und sechsten Variante des erfindungsgemässen Magnetfeldsensors sind dagegen im Halbleitermaterial 1 des zweiten Leitfähigkeitstyps P mehrere annähernd gleiche ladungsgekoppelte Schaltungen vorhanden, die alle elektrisch in Reihe geschaltet sind. Die Eingangzone 2 und die Ausgangszone 3 aller ladungsgekoppelten Schaltungen sowie eine der beiden Kontaktzonen 4 oder 5, z. B. die zweite Kontaktzone 5, sind dabei mittels mindestens einer elektrischen Verbindung 47 miteinander verbunden, während die andere der beiden Kontaktzonen 5 oder 4, z. B. die erste Kontaktzone 4, zentral zu den ladungsgekoppelten Schaltungen angeordnet ist. Die beiden Enden mindestens einer mittleren der Gatelektroden einer jeden ladungsgekoppelten Schaltung sind überlappend über je eine der beiden Kontaktzonen 4 und 5 angeordnet. In der Fig. 6 und der Fig. 7 sind die vier mittleren Gateelektroden 15 bis 18 einer jeden ladungsgekoppelten Schaltung über die Kontaktezonen 4 und 5 teilweise überlappend angeordnet.

In der in der Fig. 6 dargestellten fünften Variante des erfindungsgemässen Magnetfeldsensors sind zwei ladungsgekoppelte Schaltungen 51 und 52 im Halbleitermaterial 1 des zweiten Leitfähigkeitstyps P vorhanden und räumlich parallel angeordnet. In dieser fünften Variante werden Ladungsträger in zwei parallelen, jedoch entgegengesetzten Richtungen durch die beiden ladungsgekoppelten Schaltungen transportiert.

In der in der Fig. 7 dargestellten sechsten Variante des erfindungsgemässen Magnetfeldsensors sind vier ladungsgekoppelte Schaltungen 51 bis 54 im Halbleitermaterial 1 des zweiten Leitfähigkeitstyps P vorhanden, wobei die zentral angeordnete Kontaktzone 4 in der Draufsicht die Gestalt eines Kreuzes besitzt. Die vier ladungsgekoppelten Schaltungen 51 bis 54 sind um die zentral angeordnete erste Kontaktzone 4 entlang je einer Seite eines Vierecks angeordnet, deren Seiten parallel zu den Balkenachsen des Kreuzes verlaufen. Jeder ladungsgekoppelten Schaltung 51, 52, 53 und 54 ist ein halber Kreuzbalken zugeordnet. Die vier mittleren Gateelektroden 15 bis 18 einer jeden ladungsgekoppelten Schaltung 51, 52, 53 und 54 überlappen jeweils das Ende des der betreffenden ladungsgekoppelten Schaltung zugeordneten halben Kreuzbalkens. In dieser sechsten Variante werden Ladungsträger in vier unterschiedlichen Richtungen transportiert.

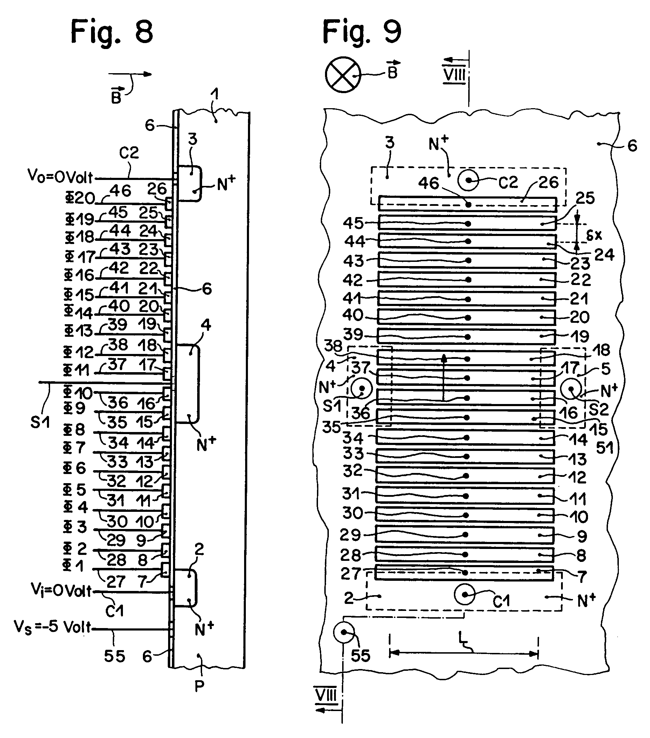

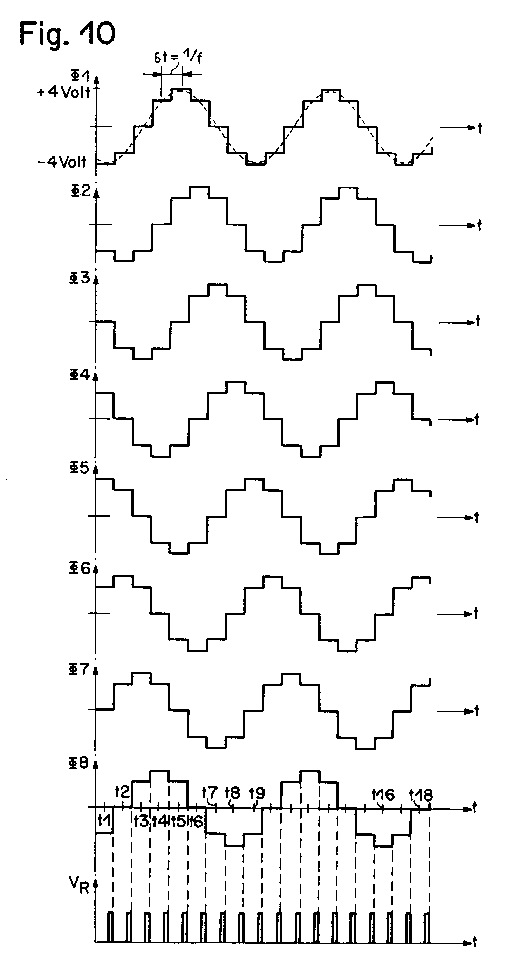

In der Fig. 8 und der Fig. 9 ist die erste Variante der erfindungsgemässen Anordnung noch einmal, diesmal ausführlich dargestellt. Dabei steht an jedem der zwanzig Gateanschlüsse 27 bis 46 der Gateelektroden 7 bis 26 eine Gatespannung $\Phi1$, $\Phi2$, ..., $\Phi19$ bzw. $\Phi20$ an, deren zeitlicher Verlauf in den acht ersten Zeilen der Fig. 10 dargestellt ist. Die Isolierschicht 6 besitzt eine Durchführung für einen elektrischen Anschluss 55 des Halbleitermaterials 1, der an der niedrigsten Spannung $V_S$ liegt, die im Magnetfeldsensor vorhanden ist. $V_S$ ist z. B. -5 Volt. Die elektrischen Anschlüsse C1 und C2 der Eingangszone 2 und der Ausgangszone 3 liegen z. B. an 0 Volt. In diesem Fall ist die Ausgangsspannung $V_{S1,S2}$ der zweiten bis sechsten Variante des Magnetfeldsensors auf Masse bezogen, da dann wegen der elektrischen Verbindungen 47 die am Sensoranschluss S2 anstehende Spannung ebenfalls 0 Volt beträgt. Die Ausgangsspannung $V_{S1,S2}$ der ersten Variante des Magnetfeldsensors (siehe Fig. 1 und Fig. 3) kann dagegen in diesem Fall auch "schwimmend" sein. Der Abstand zwischen den Mittellinien zweier benachbarter paralleler Gateelektroden ist mit $\delta x$ bezeichnet. Der Abstand zwischen den beiden Kontaktzonen 4 und 5, parallel zur Längsrichtung der Gateelektroden 7 bis 26 gemessen, beträgt L und entspricht der wirksamen Länge der mittleren Gateelektroden 15 bis 18, die die beiden Kontaktzonen 4 und 5 teilweise überlappen.

Ladungsgekoppelte Schaltungen besitzen normalerweise nur drei Phasen, d. h. es sind nur drei in der Phase verschobene unterschiedliche Gatespannungen $\Phi1$, $\Phi2$ und $\Phi3$ vorhanden. Die für einen Magnetfeldsensor verwendeten ladungsgekoppelten Schaltungen sollten dagegen vorzugsweise mindestens vier Phasen aufweisen. Nachfolgend gilt die Annahme, dass acht Phasen vorhanden sind, d. h. dass acht in der Phase unterschiedliche Gatespannungen $\Phi1$, $\Phi2$, ..., $\Phi7$ und $\Phi8$ als Kontrollsignale für die ladungsgekoppelte Schaltung anwesend sind. In diesem Fall gilt $\Phi1 = \Phi9 = \Phi17$, $\Phi2 = \Phi10 = \Phi18$, $\Phi3 = \Phi11 = \Phi19$, $\Phi4 = \Phi12 = \Phi20$, $\Phi5 = \Phi13$, $\Phi6 = \Phi14$, $\Phi7 = \Phi15$, $\Phi8 = \Phi16$.

Die Gatespannungen $\Phi1$ bis $\Phi8$ sind in den acht ersten Zeilen der Fig. 10 in Funktion der Zeit t dargestellt. Sie besitzen je eine treppenförmige Gestalt und sind jeweils in der Zeit t um eine Dauer $\delta t = 1/f$ einer Treppenstufe gegenüber einer benachbarten vorhergehenden Gatespannung verschoben, wobei f die Taktfrequenz der Gatespannungen bezeichnet. Mit anderen Worten: $\Phi2$ ist gegenüber $\Phi1$, $\Phi3$ gegenüber $\Phi2$, $\Phi4$ gegenüber $\Phi3$, $\Phi5$ gegenüber $\Phi4$, $\Phi6$ gegenüber $\Phi5$, $\Phi7$ gegenüber $\Phi6$ und $\Phi8$ gegenüber $\Phi7$ zeitlich um $\delta t$ verschoben. Die Werte der Treppenstufen liegen dabei z. B. zwischen -4 Volt und + 4 Volt und sind diskrete Abtastwerte z. B. einer sinusförmigen Spannung. Eine solche sinusförmige Spannung ist in der ersten Zeile der Fig. 10 gestrichelt dargestellt. Zum Erhalt der diskreten Werte der Treppenstufen der Gatespannungen $\Phi1$ bis $\Phi8$ wird die Periode der sinusförmigen Spannung in einer ganzzahligen Anzahl zeitlich gleich langer Zeitintervalle $\delta t$ unterteilt, wobei die ganzzahlige Anzahl der Anzahl vorhandener Phasen entspricht und in der Zeichnung gleich acht ist. In der Fig. 10 sind jeweils achtzehn Treppenstufen pro Gatespannung dargestellt, deren zeitliche Mittelwerte den Zeitpunkten t1, t2, ..., t17 und t18 entsprechen. Die diskreten Werte der Gatespannungen, d. h. die Werte der Treppenstufen, sind dann z. B. die Werte der sinusförmigen Spannung in den Zeitpunkten t1 bis t18 in der Mitte der Dauer $\delta t$ einer jeden der achtzehn Treppenstufen. Statt der sinusförmigen Spannung kann auch z. B. eine nicht dargestellte, in Funktion der Zeit t periodische sägezahnförmige Spannung verwendet werden.

Wenn in der zweiten Variante (siehe Fig. 2) eine Lese-Gateelektrode 48 vorhanden ist, dann muss an deren elektrischen Anschluss 49 eine elektrische Spannung $V_R$ angelegt werden, deren zeitlicher Verlauf in der neunten Zeile der Fig. 10 dargestellt ist. Die Spannung $V_R$ besteht aus einer Reihe sehr kurzer rechteckförmiger Impulse, die zeitlich mit dem Ende der Treppenstufen der Gatespannungen $\Phi1$ bis $\Phi8$ übereinstimmen, wobei die fallenden Flanken der Impulse der Spannung $V_R$ zeitlich mit den Kanten der Treppenstufen der Gatespannungen $\Phi1$ bis $\Phi8$ bündig sind. Die Spannung $V_R$ gestattet ein getastetes Lesen der an den Teilkontaktzonen 4A bis 4D anstehenden Spannungen. Dadurch wird ein Kurzschlusseffekt eliminiert, der dadurch entsteht, dass die elektrisch sehr gut leitenden Kontaktzonen 4 und 5 in der Regel mehrere in den ladungsgekoppelten Schaltungen vorhandenen Ladungsträgerpakete an deren beiden Enden kurzschliessen. Bei dem getasteten Lesen wird mittels der Lese-Gateelektrode 48 jeweils nur ein einziges, sich unter einer einzigen Gateelektrode befindliches Ladungsträgerpaket, welches sich im Kontakt mit einer einzigen der Teilkontaktzonen 4A, 4B, 4C oder 4D befindet, am Ende einer Transferperiode, d. h. am zeitlichen Ende einer Treppenstufe, kurzzeitig während der Dauer eines rechteckförmigen Impulses der Spannung $V_R$ auf die weitere Kontaktzone 50 und damit auf den Sensoranschluss S1 des Magnetfeldsensor-Ausganges geschaltet.

Anhand der Fig. 11 soll nun kurz die Arbeitsweise des erfindungsgemässen Magnetfeldsensors erläutert werden. In der ersten Zeile der Fig. 11 ist ein schematischer Querschnitt der ersten Variante des erfindungsgemässen Magnetfeldsensors dargestellt. Zu einem jeden der Zeitpunkte t1, t2, ..., t7 bzw. t8 steht in der Richtung x der Gateelektroden 7 bis 26 eine treppenförmige Spannung an der Gesamtheit der Gateelektroden 7 bis 26 an, denen an der Aussenfläche im Halbleitermaterial 1 unterhalb der Gateelektroden 7 bis 26 eine potentielle elektrische Energie $E_{P1}$, $E_{P2}$, ... , $E_{P7}$ bzw. $E_{P8}$ entspricht, deren in Funktion von x treppenförmiger Verlauf in den acht letzten Zeilen der Fig. 11 dargestellt ist. Dabei entspricht $\delta x$ dem Abstand in der Richtung x zwischen den Mitten zweier aufeinanderfolgender Treppenstufen. Zwischen der Eingangszone 2 sowie der Ausgangzone 3 und der am nächsten liegenden mittleren, die Kontaktzonen 4 und 5 teilweise überlappenden Gateelektrode 15 bzw. 18 sollen mindestens soviele Treppenstufen vorhanden sein, wie Phasen vorhanden sind. In der Zeichnung sind dies also mindestens acht Treppenstufen. Die räumlichen Bereiche δx, die die niedrigste potentielle elektrische Energie aufweisen, sind Potentialsenken ("potential wells"). Sie sind mit Elektronen gefüllt und in der Fig. 11 schraffiert dargestellt. Diese schraffierten Bereiche werden auch als bezeichnet. Unterhalb der Eingangszone 2 und der Ausgangszone 3 ist ebenfalls eine sehr niedrige potentielle elektrische Energie vorhanden, so dass auch diese Bereiche in der Fig. 11 schraffiert dargestellt sind.

Die stark mit Fremdatomen dotierte Eingangszone 2 dient als Ladungsträgerquelle zur Erzeugung neuer Ladungsträgerpakete, die beim nächsten Takt der Gatespannung Φ1 unter die erste Gateelektrode 7 geschoben wird. In jeder Potentialsenke erscheint eine Ladungsträger-Inversionsschicht, welche lokal ein Ladungsträgerpaket der Breite δx bildet. Wie aus der Fig. 11 ersichtlich, bewegt sich die Potentialsenke und damit auch das zugehörige Ladungsträgerpaket, welche sich im Augenblick t1 unter der ersten Gateelektrode 7 befinden, schrittweise, in der Darstellung der Zeichnung von links nach rechts, entlang der Aussenfläche des Halbleitermaterials 1, so dass sie sich im Augenblick t2 unter der Gateelektrode 8, im Augenblick t3 unter der Gateelektrode 9, im Augenblick t4 unter der Gateelektrode 10, im Augenblick t5 unter der Gateelektrode 11, im Augenblick t6 unter der Gateelektrode 12, im Augenblick t7 unter der Gateelektrode 13, im Augenblick t8 unter der Gateelektrode 14, usw., befindet. Im nicht mehr dargestellten Augenblick t21 wird sie schliesslich die Ausgangszone 3 erreichen. Die Gatespannungen Φ1 bis Φ8 erzeugen somit eine Art elektrischer Potentialwellen, die sich entlang der Aussenfläche des Halbleitermaterials 1 fortbewegen. Die Ausgangszone 3 fängt am Ende die ankommenden und von der letzten Gateelektrode 26 gelieferten Ladungsträgerpakete auf. Die Funktionen der Eingangszone 2 und der Ausgangszone 3 sind dabei, selbst mitten im Betrieb, gegeneinander austauschbar und bestimmen jeweils die Transportrichtung der Ladungsträgerpakete.

In der dritten und vierten Variante fehlen jeweils die Eingangszone 2 und die Ausgangszone 3. In diesem Fall werden die Ladungsträgerpakete durch interne Ladungsträgergeneration im Halbleitermaterial 1 erzeugt, wobei die generierten Ladungsträgerpakete sich langsam, nach einer gewissen Zeit in der Grössenordnung von einigen Sekunden, unterhalb denjenigen Gateelektroden ansammeln, denen eine Potentialsenke entspricht.

Nach dem Anlegen geeigneter Gatepannungen Φ1 bis Φ8 an die Gateelektroden 7 bis 26 der ladungsgekoppelten Schaltungen 51 bis 54 bewegen sich längliche Ladungsträgerpakete in der Richtung x entlang der Aussenfläche des Halbleitermaterials 1, auf der die Gateelektroden 7 bis 26 angeordnet sind. In ladungsgekoppelten Schaltungen werden somit längliche Ladungsträgerpakete erzeugt, die sich unter dem Einfluss der Gatespannungen Φ1 bis Φ8 durch die aktive Zone der ladungsgekoppelten Schaltungen hindurchbewegen, wobei der Ladungsträgertransfer nicht auf einem gewöhnlichen Drift- oder Diffusionseffekt beruht. In der Zeichnung ist die Transportrichtung der Ladungsträgerpakete jeweils durch einen Pfeil dargestellt.

Die mittlere Geschwindigkeit der Ladungsträger, z. B. der Elektronen, die sich ähnlich wie Wellenreiter auf Wasserwellen, auf elektrische Potentialwellen fortbewegen, ist gleich der Gruppengeschwindigkeit der elektrischen Potentialwellen. Wenn in erster Annäherung die thermische Bewegung der Ladungsträger vernachlässigt wird, dann ist die Geschwindigkeit der Ladungsträger gleich der Geschwindigkeit v der Ladungsträgerpakete, welche ausschliesslich von der Geometrie des Bauelementes, insbesondere vom Abstand δx zwischen den Mittellinien zweier benachbarter Gateelektroden, und von der Taktfrequenz f der Gatespannungen Φ1 bis Φ8 abhängig ist, da $v = δx/δt = δx.f$. Damit sich die Ladungsträgerpakete möglichst "weich" entlang der Aussenfläche des Halbleitermaterials 1 fortbewegen, sollte die ladungsgekoppelte Schaltung möglichst viele Phasen, in jedem Fall mehr als drei Phasen besitzen, da die Fortbewegungsschritte der Ladungsträgerpakete dann kleiner sind, bei einer gegegebenen Periode des sinusförmigen bzw. sägezahnförmigen Signals, welches der Erzeugung der diskreten Werte der Gatespannungen dient.

Die bis hierher beschriebene Arbeitsweise der ladungsgekoppelten Schaltung ist die übliche und an sich bekannte Funktionsweise der letzteren, welche so allein, ohne Änderung der ladungsgekoppelten Schaltung, nicht zum Messen von Magnetfeldern verwendet werden kann. Die konventionellen ladungsgekoppelten Schaltungen sind bezüglich "timing" und Ladungsquantität im transportierten Ladungsträgerpaket optimiert. In der im erfindungsgemässen Magnetfeldsensor verwendeten ladungsgekoppelten Schaltung ist das "timing" zwar auch wichtig, jedoch ist die Ladungsquantität im Ladungsträgerpaket von sekundärer Bedeutung.

Nachfolgend wird nun die Arbeitsweise des erfindungsgemässen Magnetfeldsensors beschrieben, die erst aus der ladungsgekoppelten Schaltung eine Anordnung zum Messen von Magnetfeldern macht.

Wenn die ladungsgekoppelte Schaltung einem Magnetfeld bzw. einer dazugehörigen Magnetfeldinduktion B ausgesetzt ist, die in den sechs ersten Varianten senkrecht zur Aussenfläche des Halbleitermaterials 1 verläuft, dann unterliegt jedes sich bewegende und dem Magnetfeld bzw. der Magnetfeldinduktion B ausgesetzte Ladungsträgerpaket einer Lorentzkraft F, deren Richtung parallel zur Längsrichtung der Ladungsträgerpakete und somit auch parallel zur Längsrichtung der Gateelektroden 7 bis 26 ist.

Dabei gilt: F = q.(v.B),
wobei q die Ladung der Ladungsträger, z. B. der Elektronen, ist.

Die Lorentzkraft F erzeugt eine Anreicherung einer Seite der Ladungsträgerpakete und eine Verarmung der anderen Seite der Ladungsträgerpakete jeweils an Ladungsträgern. Diese ungleiche Verteilung von Ladungsträgern entlang der länglichen Ladungsträgerpakete ist Ursache eines elektrischen Feldes entlang der Ladungsträgerpakete und damit einer Spannungsdifferenz zwischen deren beiden Enden, die um so grösser ist, je länger die Ladungsträgerpakete und je grösser die wirksame Längen L der mittleren Gateelektroden 15 bis 18 sind. Da die beiden Enden der sich unter den mittleren Gateelektroden 15 bis 18 befindlichen Ladungsträgerpakete mindestens zeitweise elektrischen Kontakt mit den Kontaktflächen 4 und 5 und damit auch mit den Sensoranschlüssen S1 und S2 besitzen, ist die erwähnte Spannungsdifferenz gleich der Ausgangsspannung $V_{S1,S2}$ des Magnetfeldsensors.

Dabei gilt: $V_{S1,S2}$ = v.B.L = $V_{S1,S2}$ = δx.f.B.L
Die so ermittelte, an den Sensoranschlüssen S1 und S2 des Magnetfeldsensors anstehende Ausgangsspannung ist proportional der Magnetfeldinduktion B, proportional der wirksamen Länge L der mittleren Gateelektroden 15 bis 18 und proportional der Geschwindigkeit der Ladungsträgerpakete, die ihrerseits, wie bereits erwähnt, nur von δx und von der Taktfrequenz der Gatespannungen Φ1 bis Φ8 abhängig ist. Dabei sind L und δx ausschliesslich Geometrieparameter des Magnetfeldsensors. Die Ausgangsspannung $V_{S1,S2}$ des erfindungsgemässen Magnetfeldsensors ist somit im Gegensatz zu derjenigen eines Halleffekt-Bauelementes unabhängig von den Speisespannungs-Bedingungen, der Ladungsträger-Mobilität, der Ladungsträger-Dichte und den Umgebungsbedingungen.

Mit δx = 10μ, L = 1mm, B = 1 Tesla und f = 10 MHz ist z. B. $V_{S1,S2}$ = 100 mV.

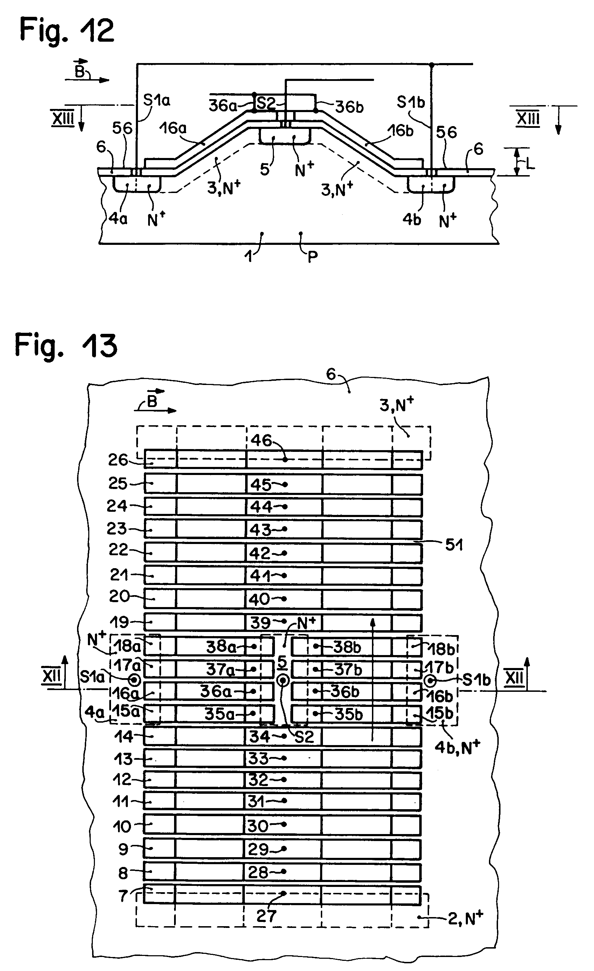

Die siebte, in der Fig. 12 und in der Fig. 13 dargestellte Variante des erfindungsgemässen Magnetfeldsensors dient der Messung von Magnetfeldern bzw. Magnetfeldinduktionen B, die parallel zur Aussenfläche des Halbleitermaterials 1 wirksam sind.

Die dargestellte siebte Variante ist ähnlich aufgebaut wie die erste Variante mit folgenden Unterschieden: In der siebten Variante besitzt die mit der Isolierschicht 6 bedeckte Aussenfläche des Halbleitermaterials 1 des zweiten Leitfähigkeitstyps P mindestens am Ort einer jeden ladungsgekoppelten Schaltung die Gestalt eines mit einer Bodenfläche 56 versehenen länglichen Hügels, der senkrecht zu seiner Längsachse einen annähernd trapezförmigen Querschnitt aufweist und der an seinem Fuss von der Bodenfläche 56 umgeben ist. Dabei ist einer jeden ladungsgekoppelten Schaltung ein solcher Hügel zugeordnet. In der Fig. 13 ist nur eine einzige ladungsgekoppelte Schaltung 51 dargestellt. Die Hügel werden z. B. mit einer konventionellen V-Graben-Ätztechnik hergestellt.

Annähernd in der Mitte des Gipfels eines jeden Hügels sind die zweite Kontaktzone 5 sowie beidseitig auf gleicher Höhe am Fusse des Hügels in der Bodenfläche 56 je zwei Hälften 4a und 4b der ersten Kontaktzone 4 angeordnet, wobei die beiden Hälften 4a und 4b, extern elektrisch miteinander verbunden, zusammen die erste Kontaktzone 4 bilden. Die Gateelektroden 7 bis 26, die Eingangszone 2 und die Ausgangszone 3 einer jeden ladungsgekoppelten Schaltung sind streifenförmig und parallel entlang dem äusseren Umfang von trapezförmigen Querschnitten eines zugehörigen Hügels angeordnet, wobei sie unten an beiden Seiten des jeweiligen Hügels einen Teil der Bodenfläche 56 bedecken und wobei mindestens eine mittlere Gatelektrode 15, 16, 17 oder 18 einer jeden ladungsgekoppelten Schaltung in ihrer Mitte auf dem Gipfel des Hügels unterbrochen ist, so dass sie aus zwei Z-förmigen Teilgateelektroden 15a, 15b bzw. 16a, 16b bzw. 17a, 17b bzw. 18a, 18b besteht, deren beiden Enden mindestens teilweise überlappend jeweils über die zweite Kontaktzone 5 und eine zugehörige Hälfte 4a bzw. 4b der ersten Kontaktzone 4 angeordnet sind. Die beiden Hälften 4a und 4b bestehen aus einem stark mit Fremdatomem dotiertem Halbleitermaterial des ersten Leitfähigkeitstyps $N^+$ und weisen je einen Sensoranschluss S1a bzw. S1b auf, die beide Durchführungen der Isolierschicht 6 durchqueren, um extern elektrisch miteinander verbunden zu werden. In der Fig. 13 wurde angenommen, dass alle vier Gateelektroden 15 bis 18 in zwei Teilgateelektroden unterteilt sind. Jede der Teilgateelektroden 15a bis 18a und 15b bis 18b besitzt je einen Gateanschluss 35a, 36a, 37a, 38a, 35b, 36b, 37b oder 38b, wobei die Gateanschlüsse 35a und 35b, 36a und 36b, 37a und 37b sowie 38a und 38b jeweils unter sich extern elektrisch verbunden sind.

Die Länge der Gateelektroden kann vektoriell in eine wirksame Länge L, die eine senkrecht zur Bodenfläche 56 verlaufende Richtung besitzt, und in eine unwirksame Länge zerlegt werden, die parallel zur Bodenfläche 56 verläuft. Die Richtung des zu messenden Magnetfeldes bzw. der dazugehörigen Magnetfeldinduktion B und die Richtung der Ladungsträgerpakete sind wieder senkrecht unter sich und senkrecht zur wirksamen Länge L der Gateelektroden 7 bis 26, so dass die siebte Variante wieder ähnlich arbeitet wie die sechs ersten Varianten.

## Patentansprüche

1. Magnetfeldsensor mit einer ersten Kontaktzone (4 bzw. 4A bis 4D) sowie einer zweiten Kontaktzone (5), die beide aus einem Halbleitermaterial eines ersten Leitfähigkeitstyps ($N^+$) bestehen, an einer Aussenfläche in einem Halbleitermaterial (1) eines zweiten Leitfähigkeitstyps (P) angeordnet sind und denen je ein Sensoranschluss (S1 bzw. S2) zugeordnet ist, und mit einer auf der Aussenfläche des Halbleitermaterials (1) des zweiten Leitfähigkeitstyps (P) angeordneten und mit Durchführungen für die Sensoranschlüsse (S1, S2) versehenen Isolierschicht (6), dadurch gekennzeichnet, dass die erste und zweite Kontaktzone (4, 5) stark mit Fremdatomen dotiert sind, dass auf der Isolierschicht (6) Gateelektroden (7 bis 26) mindestens einer ladungsgekoppelten Schaltung (51, 52, 53, 54) angeordnet sind, die in einer Richtung eine Elektrodenreihe bilden und die senkrecht zur Richtung der Elektrodenreihe länglich sind, und dass die beiden Enden mindestens einer mittleren der Gateelektroden (15, 16, 17, 18), die auf der Isolierschicht (6) zwischen den beiden Kontaktzonen (4, 5) angeordnet ist, mindestens teilweise überlappend über je eine der beiden Kontaktzonen (4 bzw. 4A;4B;4C;4D und 5) angeordnet sind.

2. Magnetfeldsensor nach Anspruch 1, dadurch gekennzeichnet, dass eine der beiden Kontaktzonen (4) zentral angeordnet ist und die andere der beiden Kontaktzonen (5) die Gestalt eines Ringes aufweist, welcher die zentral angeordnete Kontaktzone (4) distanziert umgibt, dass die länglichen Gateelektroden (7 bis 26) senkrecht zum Umfang des Ringes auf der Isolierschicht (6) zwischen den beiden Kontaktzonen (4, 5) angeordnet sind und dass die beiden Enden der Gateelektroden (7 bis 26) über je eine der beiden Kontaktzonen (4, 5) mindestens teilweise überlappend angeordnet sind.

3. Magnetfeldsensor nach Anspruch 2, dadurch gekennzeichnet, dass die zentral angeordnete Kontaktzone (4) die Gestalt eines Kreises besitzt, dass die die Gestalt eines Ringes aufweisende Kontaktzone (5) die Gestalt eines Kreisringes aufweist und dass beide Kontaktzonen (4, 5) konzentrisch sind.

4. Magnetfeldsensor nach Anspruch 1, dadurch gekennzeichnet, dass die länglichen Gateelektroden (7 bis 26) parallel angeordnet sind und, senkrecht zu ihrer Länge, eine gerade Elektrodenreihe bilden, dass eine Eingangszone (2) und eine Ausgangszone (3) der ladungsgekoppelten Schaltung (51, 52, 53, 54) im Halbleitermaterial (1) des zweiten Leitfähigkeitstyps (P) angeordnet sind, die beide aus einem stark mit Fremdatomen dotierten Halbleitermaterial des ersten Leitfähigkeitstyps ($N^+$) bestehen, und dass die senkrecht zur Richtung der Elektrodenreihe verlaufenden Dimensionen der Gateelektroden (7 bis 26), der Eingangszone (2) und der Ausgangszone (3) annähernd gleich gross sind.

5. Magnetfeldsensor nach Anspruch 4, dadurch gekennzeichnet, dass eine der beiden Kontaktzonen (5), die Eingangszone (2) und die Ausgangszone (3) alle drei mittels mindestens einer elektrischen Verbindung (47) miteinander verbunden sind.

6. Magnetfeldsensor nach Anspruch 4, dadurch gekennzeichnet, dass im Halbleitermaterial (1) des zweiten Leitfähigkeitstyps (P) mehrere annähernd gleiche ladungsgekoppelte Schaltungen (51 bis 54) vorhanden sind, die elektrisch in Reihe geschaltet sind, dass die Eingangszone (2) und die Ausgangszone (3) aller ladungsgekoppelten Schaltungen (51 bis 54) sowie eine der beiden Kontaktzonen (5) mittels mindestens einer elektrischen Verbindung (47) miteinander verbunden sind, während die andere der beiden Kontaktzonen (4) zentral zu den ladungsgekoppelten Schaltungen (51 bis 54) angeordnet ist, und dass die beiden Enden mindestens einer mittleren der Gatelektroden (15 bis 18) einer jeden der ladungsgekoppelten Schaltungen (51 bis 54) überlappend über je eine der beiden Kontaktzonen (4, 5) angeordnet sind.

7. Magnetfeldsensor nach Anspruch 6, dadurch gekennzeichnet, dass zwei ladungsgekoppelte Schaltungen (51, 52) im Halbleitermaterial (1) des zweiten Leitfähigkeitstyps (P) vorhanden und räumlich parallel angeordnet sind.

8. Magnetfeldsensor nach Anspruch 6, dadurch gekennzeichnet, dass vier ladungsgekoppelte Schaltungen (51 bis 54) im Halbleitermaterial (1) des zweiten Leitfähigkeitstyps (P) vorhanden sind, dass die zentral angeordnete Kontaktzone (4) die Gestalt eines Kreuzes besitzt und dass die vier ladungsgekoppelten Schaltungen (51 bis 54) um die zentral angeordnete Kontaktzone (4) entlang je einer Seite eines Vierecks angeordnet sind, deren Seiten parallel zu den Balkenachsen des Kreuzes verlaufen.

9. Magnetfeldsensor nach einem der Ansprüche 5 bis 8, dadurch gekennzeichnet, dass die elektrische Verbindung (47) aus einem stark mit Fremdatomen dotierten Halbleitermaterial des ersten Leitfähigkeitstyps ($N^+$) besteht.

10. Magnetfeldsensor nach einem der Ansprüche 1 bis 9, dadurch gekennzeichnet, dass die mit der Isolierschicht (6) bedeckte Aussenfläche des Halbleitermaterials (1) des zweiten Leitfähigkeitstyps (P) mindestens am Ort einer jeden ladungsgekoppelten Schaltung (51, 52, 53, 54) die Gestalt eines länglichen Hügels besitzt, der senkrecht zu seiner Längsachse einen annähernd trapezförmigen Querschnitt aufweist und der an seinem Fuss von einer Bodenfläche (56) umgeben ist, dass annähernd in der Mitte des Gipfels eines jeden Hügels die zweite Kontaktzone (5) sowie beidseitig auf gleicher Höhe am Fusse des Hügels in der Bodenfläche (56) je zwei Hälften (4a, 4b) der ersten Kontaktzone (4) angeordnet sind, wobei die beiden Hälften (4a, 4b), extern elektrisch miteinander verbunden, zusammen die erste Kontaktzone (4) bilden, dass die Gateelektroden (7 bis 26), die Eingangszone (2) und die Ausgangszone (3) einer jeden ladungsgekoppelten Schaltung (51, 52, 53, 54) streifenförmig sind und parallel entlang dem äusseren Umfang von trapezförmigen Querschnitten eines zugehörigen Hügels angeordnet sind, wobei sie unten an beiden Seiten des jeweiligen Hügels einen Teil der Bodenfläche (56) bedecken und wobei mindestens eine mittlere der Gateelektroden (15 bzw. 16 bzw. 17 bzw. 18) einer jeden ladungsgekoppelten Schaltung (51, 52, 53, 54) in ihrer Mitte auf dem Gipfel des Hügels unterbrochen ist, so dass sie aus zwei Z-förmigen Teilgateelektroden (15a, 15b bzw. 16a, 16b bzw. 17a, 17b bzw. 18a, 18b) besteht, deren beiden Enden mindestens teilweise überlappend jeweils über die zweite Kontaktzone (5) und eine zugehörige Hälfte (4a bzw. 4b) der ersten Kontaktzone (4) angeordnet sind.

11. Magnetfeldsensor nach einem der Ansprüche 1 bis 10, dadurch gekennzeichnet, dass mindestens eine der beiden Kontaktzonen (4) aus mehreren Teilkontaktzonen (4A, 4B, 4C, 4D) besteht, die annähernd gleich breit sind wie die Gateelektroden (7 bis 26) und denen je eine aufeinanderfolgende, unterschiedliche mittlere der Gateelektroden (15 bzw. 16 bzw. 17 bzw. 18) zugeordnet ist, deren eines Ende über die zugehörige Teilkontaktzone (4A bzw. 4B bzw. 4C bzw. 4D) mindestens teilweise überlappend angeordnet ist [oder mindestens einen Abstand in der Grössenodnung eines Mikrometers zu einer Kante der betreffenden Teilkontaktzonen (4A, 4B, 4C, 4D) aufweist], und dass auf der Isolierschicht (6) mindestens eine Lese-Gateelektrode (48) angeordnet ist, die jeweils über die Teilkontaktzonen (4A, 4B, 4C, 4D) und eine weitere Kontaktzone (50) mindestens teilweise überlappend angeordnet ist, wobei die weitere Kontaktzone (50) mit demjenigen Sensoranschluss (S1) verbunden ist, der der aus mehreren Teilkontaktzonen (4A, 4B, 4C, 4D) bestehenden Kontaktzone (4) zugeordnet ist, aus einem stark mit Fremdatomen dotierten Halbleitermaterial des ersten Leitfähigkeitstyps ($N^+$) besteht und an der Aussenfläche in das Halbleitermaterial (1) des zweiten Leitfähigkeitstyps (P) angeordnet ist.

# Fig. 1

# Fig. 2

# Fig. 3

# Fig. 5

# Fig. 4

## Fig. 6

## Fig. 7

# Fig. 8

# Fig. 9

# Fig. 10

# Fig. 11

## Fig. 12

## Fig. 13

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5 ) |
|---|---|---|---|
| Y | US-A-3 906 359 (F.C.BLAHA E.A.)<br>* Zusammenfassung; Abbildungen 1,2 *<br>--- | 1-4 | G01R33/06 |
| Y | DE-A-3 325 148 (R.POPOVIC E.A.)<br>* Ansprüche 1-3; Abbildung 2 *<br>--- | 1-4 | |
| A | GB-A-1 473 430 (STANDARD TELEPHONES AND CABLES LTD)<br>* Seite 1, Zeile 78 - Seite 2, Zeile 12; Abbildungen 1,2 *<br>--- | 1,4 | |
| A | IBM TECHNICAL DISCLOSURE BULLETIN.<br>Bd. 14, Nr. 11, 1. April 1972, NEW YORK US<br>W.CHANG E.A.: 'charge coupled device magnetic field sensor'<br>----- | 1 | |

**RECHERCHIERTE SACHGEBIETE (Int. Cl.5 )**

G01R
H01L

Der vorliegende Recherchenbericht wurde für alle Patentansprüche erstellt

| Recherchenort | Abschlußdatum der Recherche | Prüfer |
|---|---|---|
| DEN HAAG | 04 AUGUST 1992 | HAASBROEK J.N. |

KATEGORIE DER GENANNTEN DOKUMENTE

X : von besonderer Bedeutung allein betrachtet
Y : von besonderer Bedeutung in Verbindung mit einer
    anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
    nach dem Anmeldedatum veröffentlicht worden ist
D : in der Anmeldung angeführtes Dokument
L : aus andern Gründen angeführtes Dokument
.............................................................................................
& : Mitglied der gleichen Patentfamilie, übereinstimmendes
    Dokument

EPO FORM 1503 03.82 (P0403)